# EUROPEAN PATENT SPECIFICATION

(11) **EP 0 579 227 B1**
(45) Date of publication and mention of the grant of the patent: **10.05.2000**
(21) Application number: 93111377.3
(22) Date of filing: 15.07.1993
(51) Int. Cl.: B28D 5/02, B28D 7/04

(54) **Method and apparatus for slicing semiconductor wafer**
Verfahren und Vorrichtung zum Abschneiden einer Halbleiterscheibe
Procédé et dispositif pour découper une plaquette semi-conductrice

(30) Priority: 16.07.1992 JP 18936992; 04.11.1992 JP 29531392
(43) Date of publication of application: 19.01.1994
(73) Proprietor: TOKYO SEIMITSU CO.,LTD., Mitaka-shi Tokyo (JP)
(72) Inventor: Honda, Katsuo, Mitaka-shi, Tokyo (JP)
(74) Representative: Hering, Hartmut, Dipl.-Ing.

(56) References cited:
- FR-A- 2 469 259
- JP-A- 62 127 206
- US-A- 3 025 738
- US-A- 3 039 235
- US-A- 3 232 009
- US-A- 4 127 969

## Description

The present invention relates to a method and an apparatus for slicing semiconductor wafers.

From JP-A-62-727 206 or US-A- 4 727 969 there is known a method of slicing a semiconductor wafer as set out in the preamble of claim 1 as well as an apparatus and set in the preamble of claim 5.

In general, a columnar semiconductor material (hereafter, it is called "workpiece") is sliced with a thin cutting edge to manufacture thin pieces like semiconductor wafers. An inner peripheral cutting edge of the doughnut-shaped blade in which diamond grains are electro deposited on the inner peripheral edge as the cutting edge. This inner peripheral cutting edge is stretched out at the outer peripheral side of the blade with a predetermined tension by the blade holding device to slice workpieces with high accuracy.

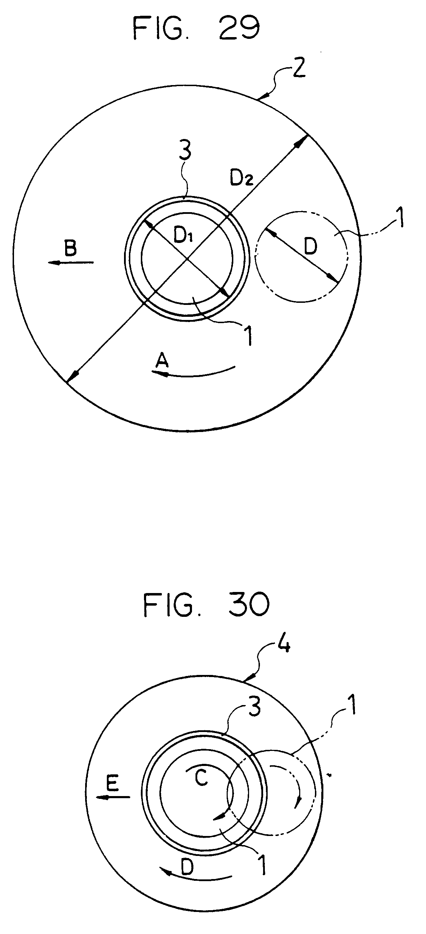

One of conventional methods for slicing semiconductor wafers with the inner peripheral cutting edge, as shown in Fig. 29, is a method in which the workpiece 1 is moved in the direction of an arrow B to be cut by the inner peripheral cutting edge 3 in the state the blade 2 is rotating to the direction of an arrow A.

However, in this method for slicing, when an inside diameter of the blade 2 is D1 and an outside diameter thereof is D2, it is necessary that a difference "(D2-D1)2" (hereafter, it is called, "effective blade length") between inside and outside diameters of the blade 2 is larger than a diameter D of the workpiece 1.

The blade 2 is formed by press punching a thin rolled band plate, and has no sense of direction externally for its circle-shape, however, differences of tensile strength are intrinsically existed in the rolling direction and in the orthogonal direction thereof. Consequently, when the diameter of the blade 2 becomes larger, the tension adjustment of the blade 2 becomes more difficult.

Therefore, the above-mentioned method has disadvantages in that the rigidity of the blade 2 is decreased to lower the processing accuracy of semiconductor wafers and the tension adjustment of the blade becomes extremely difficult, when the inside and outside diameters of the blade 2 become larger according as the diameter of the workpiece 1 is made bigger.

Then, the method explained in Fig. 30 is proposed as a method for slicing semiconductor wafers which solves such disadvantages. This method for slicing is that; the workpiece 1 is cut in a state that the workpiece 1 is rotated in the direction of an arrow C and the blade 4 is rotated in the direction of an arrow D and moved in the direction of an arrow E.

According to this method, an effective blade length of the blade 4 can be adjusted to 1/2 of the workpiece diameter since the workpiece 1 can be cut in the state the workpiece 1 is rotating. Therefore, it is possible to make the blade 4 smaller than the blade 2 shown in Fig. 29.

However, the conventional method for slicing semiconductor wafers shown in Fig. 30 has a disadvantage in that a apex projection (a cut remainder part) remains at the center of the cut semiconductor wafer.

The present invention aims at proposing a method and an apparatus for slicing semiconductor wafers, wherein an effective blade length of a blade can be made smaller than a diameter of a semiconductor material and a cut remainder part is not left at a center of a semiconductor wafer. According to one aspect of the invention there is provided,

a method for slicing semiconductor wafers as set out in claim 1.

Preferred embodiments of the method are defined in claim 2 to 4.

According to a second aspect of the invention there is provided an apparatus for slicing semiconductor wafers as set in claim 5.

Preferred embodiments of the apparatus are defined in claims 6 to 9.

### BRIEF DESCRIPTION OF THE DRAWINGS

The exact nature of this invention, as well as other objects and advantages thereof, will be readily apparent from consideration of the following specification relating to the accompanying drawings, in which like reference characters designate the same or similar parts throughout the figures thereof and wherein:
Fig. 1 is an explanatory view showing the first embodiment of an apparatus for slicing semiconductor wafers according to the invention;
Fig. 2 is the first embodiment showing cut loci of the semiconductor wafer cut by the apparatus for slicing semiconductor wafers shown in Fig. 1;
Fig. 3 is the second embodiment showing cut loci of the semiconductor wafer cut by the apparatus for slicing semiconductor wafers shown in Fig. 1;
Fig. 4 is the third embodiment showing cut loci of the semiconductor wafer cut by the apparatus for slicing semiconductor wafers shown in Fig. 1;
Fig. 5 is the fourth embodiment showing cut loci of the semiconductor wafer cut by the apparatus for slicing semiconductor wafers shown in Fig. 1;
Fig. 6 is an explanatory view showing a local displacement of an inner peripheral cutting edge;
Fig. 7 is an explanatory view showing a cutting speed of an inner peripheral cutting edge;
Fig. 8 is an explanatory view showing a cutting speed of an inner peripheral cutting edge according to the second embodiment;
Fig. 9 is the fifth embodiment showing a cutting locus of the semiconductor wafer cut by the apparatus for slicing semiconductor wafers shown in Fig. 1;
Fig. 10 is an explanatory view showing the second embodiment of an apparatus for slicing semiconductor wafers according to the invention;
Fig. 11 is an embodiment showing cut loci of the semiconductor wafer cut by the apparatus for slicing semiconductor wafers shown in Fig. 10;
Fig. 12 is an explanatory view showing the third embodiment of an apparatus for slicing semiconductor wafers according to the invention;
Fig. 13 is the first embodiment showing cut loci of the semiconductor wafer cut by the apparatus for slicing semiconductor wafers shown in Fig. 12;
Fig. 14 is the second embodiment showing cut loci of the semiconductor wafer cut by the apparatus for slicing semiconductor wafers shown in Fig. 12;
Fig. 15 is the third embodiment showing cut loci of the semiconductor wafer cut by the apparatus for slicing semiconductor wafers shown in Fig. 12;
Fig. 16 is the first embodiment that a plane grinding mechanism is located in the apparatus for slicing semiconductor wafers;
Fig. 17 is the second embodiment that a plane grinding mechanism is located in the apparatus for slicing semiconductor wafers;
Fig. 18 is a perspective view showing the fourth embodiment of an apparatus for slicing semiconductor wafers according to the invention;
Fig. 19 is a structural section view showing the apparatus for slicing semiconductor wafers shown in Fig. 18;
Fig. 20 is a section view showing a pivoting mechanism applied to the apparatus for slicing semiconductor wafers shown in Fig. 18;
Fig. 21 is an essential plane view showing a state that a cutting surface center of a workpiece is a pivoting fulcrum;
Fig. 22 is a side section view of Fig. 21;
Fig. 23 is the first embodiment showing cut loci of the semiconductor wafer cut by the apparatus for slicing semiconductor wafers shown in Fig. 18;
Fig. 24 is an essential plane view showing a state that a position shifted from a cutting surface center of a workpiece is a pivoting fulcrum;
Fig. 25 is a side section view of Fig. 24;
Fig. 26 is the second embodiment showing cut loci of the semiconductor wafer cut by the apparatus for slicing semiconductor wafers shown in Fig. 18;
Fig. 27 is the first embodiment that a plane grinding mechanism is located in the apparatus for slicing semiconductor wafers shown in Fig. 18;
Fig. 28 is the second embodiment that a plane grinding mechanism is located in the apparatus for slicing semiconductor wafers shown in Fig. 18;
Fig. 29 is an explanatory view showing the first embodiment of a conventional method of slicing semiconductor wafers;
Fig. 30 is an explanatory view showing the second embodiment of a conventional method of slicing semiconductor wafers;

Detail description will hereunder be given of the preferred embodiment of a method and an apparatus for slicing semiconductor wafers according to the present invention with reference to the accompanying drawings.

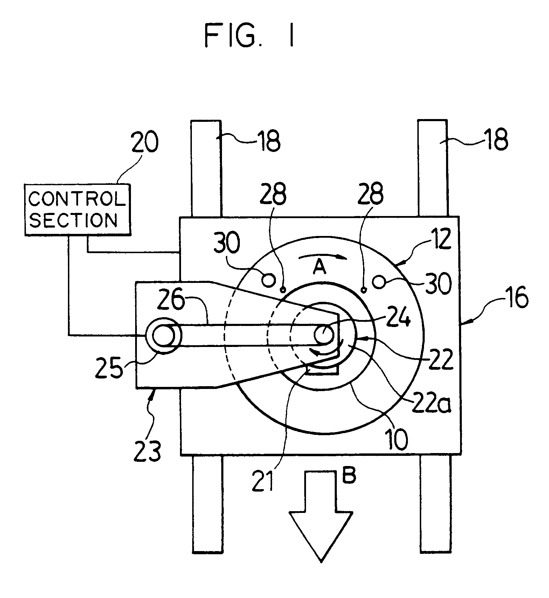

Fig. 1 is the first embodiment of an apparatus for slicing semiconductor wafers.

Diamond grains are electro deposited on the inner peripheral edge of a doughnut-shaped blade 12, whereby an inner peripheral cutting edge 10 is made up. The inner peripheral cutting edge 10 is stretched out at the outer peripheral edge of the blade 12 thereof by a chuck body not shown, and rotatable in the direction of an arrow A by turning effort from a spindle not shown. Further, the inner peripheral cutting edge 10 is held in a rectangular moving trestle 16 with the spindle.

The moving trestle 16 is mounted on rails 18 and 18 which are set at both sides of the inner peripheral cutting edge 10 in parallel to be movable in the direction of an arrow B, and driven by instruction signals from a control section 20.

A workpiece 22 is arranged on the inner peripheral cutting edge 10. The workpiece 22 is arranged under a beam member 23 which is fixed to the main body of the slicing apparatus rotatably around the axis thereof. A pulley 24 is fixed on a top part 22a of the workpiece 22 and connected with a pivoting mechanism which consists of a motor 25 and a belt 26. The motor 25 is fixed on the beam member 23 and the motor 25 is driven by the instruction signals from the control section 20.

A pair of non-contact type blade sensors 28 and 28 and air pads 30 and 30 are located in this side of the blade 12 in Fig. 1.

The blade sensors 28 and 28 is connected with the controller, not shown. The controller controls the air pressure control device, not shown, according to a displacement of the blade 12 detected by the blade sensors 28 and 28 to operate the air pads 30 and 30. Thus, the displacement (warp) of the blade 12 can be corrected.

According to the apparatus for slicing semiconductor wafers constructed in the above mentioned manner, first, the inner peripheral cutting edge 10 is rotated in the direction of the arrow A then, the moving trestle 16 is fed in the direction of the arrow B by the control section 20 to cut the workpiece 22 by the predetermined value in the state that the grindstone 14 of the inner peripheral cutting edge 10 is pressed against the workpiece 22. Next, the control section 20 stops the moving trestle 16 and drives the motor 25 to pivot the workpiece 22 about the axis thereof through the predetermined value, and then the remainder part is cut.

Therefore, the effective blade length of the blade 12 can be reduced more than the diameter of the workpiece 22. Moreover, a cut remainder part does not left at the center of the cut semiconductor wafer.

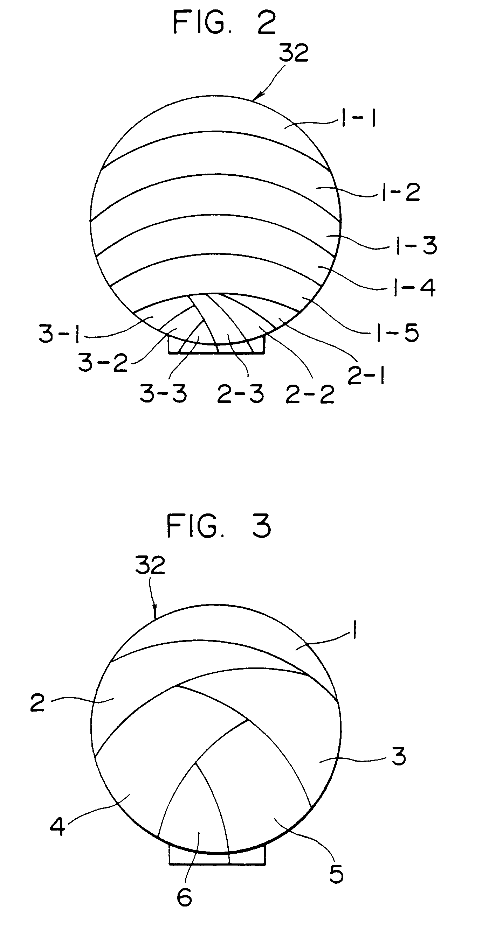

Figs. 2-5 and Fig. 9 are the embodiments showing the cutting loci on the surface of the semiconductor wafer 32 cut with the apparatus for slicing semiconductor wafers.

In Fig. 2, cut loci from 1-1 to 1-5 are put on by linear moving the moving trestle 16 shown in Fig. 1 to the direction of the arrow B and cut loci from 2-1 to 2-3 are put on by pivoting the workpiece 22 counterclockwise and stopping the moving trestle 16. The cut loci from 3-1 to 3-3 are put on by pivoting the workpiece 22 clockwise. Thus, the cut remainder part is not left at the center of the semiconductor wafer 32.

In Fig. 3, cut loci 1-6 are put on by linear moving the moving trestle 16 shown in Fig. 1 to the direction of the arrow B and pivoting the workpiece 22 alternately. In this case, the cut remainder part is also not left at the center of the semiconductor wafer 32.

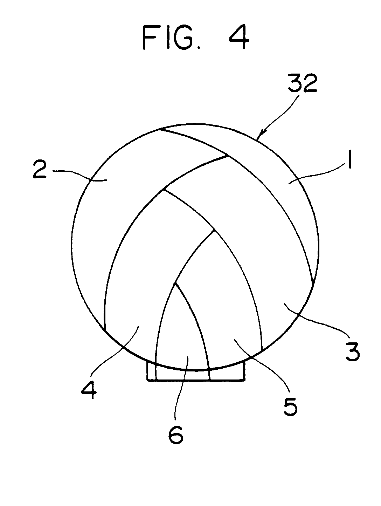

In Fig. 4, cut loci 1-6 are put on by linear feeding the moving trestle 16 at lower speed than Fig. 3 and pivoting the workpiece 22 alternately through a obtuse angle than Fig. 3. In this case, the cut remainder part is also not left at the center of the semiconductor wafer 32.

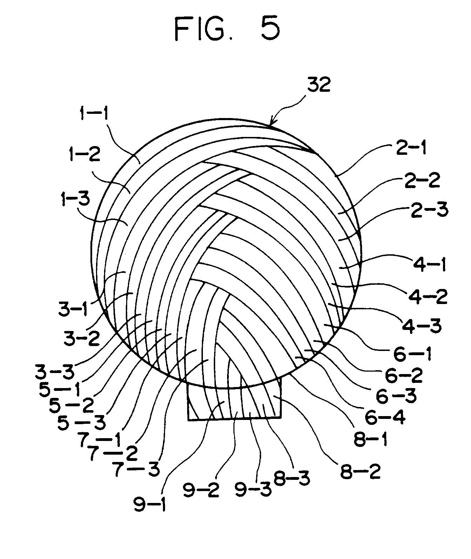

In Fig. 5, cut loci 1-6 are put on by intermittently cutting (repeating the cutting and the moving) the workpiece 22 for being pivoted counterclockwise through an acute angle and cut loci from 2-1 to 2-3 are put on by intermittently cutting the workpiece 22 for being pivoted clockwise through an acute angle. And, cut loci from 3-1, 3-2 and 3-3 to 9-1, 9-2 and 9-3 are put on by repeating the intermittently cuttings shown from 1-1 to 1-3 and from 2-1 to 2-3 alternately. Thus, the cut remainder part is not left at the center of the semiconductor wafer 32.

According to the method for slicing shown in Fig. 5, the pitch of cutting differences appeared at the border between the cuttings counterclockwise and clockwise is made much smaller than using the method for slicing semiconductor wafers disclosed in the Japan Patent Application laid-open No. 62-127206, so that flection is not appeared at the aftertreatment, such as lapping.

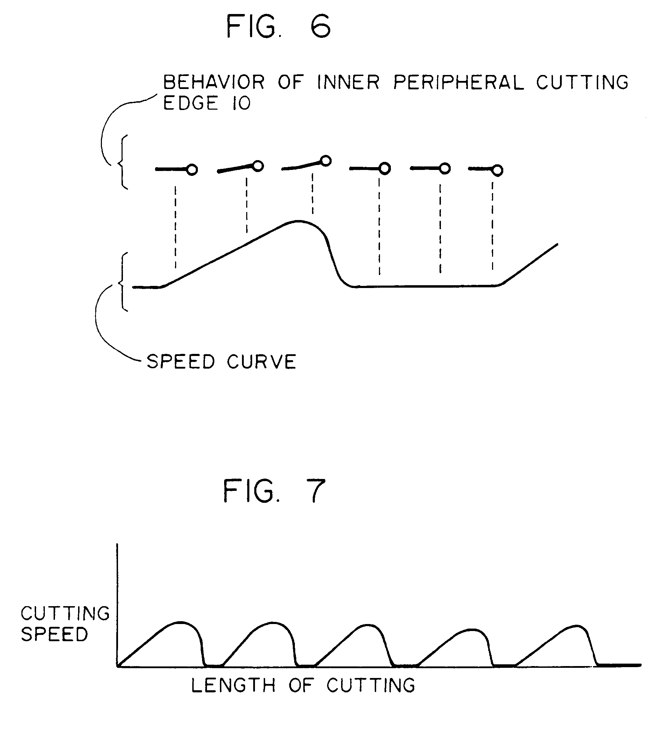

Generally, the relationships between a cutting resistance, a cutting length and the moving speed of the workpiece 22 are such that when the cutting length is longer, the cutting resistance is stronger, and when the moving speed of the workpiece 22 is higher, the cutting resistance is stronger. Further, when the cut resistance becomes stronger, the displacement of the blade 12 will obviously become larger, so that the blade 12 can easily curve. The curve of the blade 12 is detected by the pair of the non-contact type blade sensor 28 and 28. Then, in the embodiment according to this invention as shown in Fig. 6, the blade displacement becomes larger gradually as the cutting length becomes longer and when the displacement is over the predetermined value, the moving of the workpiece 22 is stopped. With this arrangement, the cutting resistance of the blade 12 becomes weak rapidly, so that the blade 12 is returning to the original position by the self restoring force (since the blade 12 is tensed previously). Thus, the displacement of the inner peripheral cutting edge 10 approaches 0. When the displacement of the inner peripheral cutting edge 10 approaches 0, the workpiece 22 is moved to the inner peripheral cutting edge 10 again. The intermittently cutting shown in Fig. 5 can be performed by repeating these steps. And, the semiconductor wafer to be cut is cut with correcting the displacement of the inner peripheral cutting edge 10 as shown in Fig. 7. Therefore, the semiconductor wafer becomes smooth.

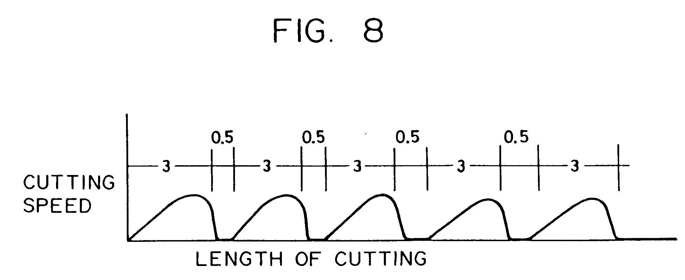

In the above embodiment, the blade sensor 28 detects the displacement of the blade 12 with and the workpiece 22 is cut intermittently based on this, however, the present invention is not limited to this. Alternatively, a linear moving time T₁, a stopping time T₂ and an intermittently pivoting time T₃ are provided previously. As shown in Fig. 8, for instance, according to one operation the workpiece 22 is pivoted counterclockwise for T₁ (three seconds), it is stopped for T₂ (0.5 second) and may be repeated for T₃ (11 seconds). According to another operation the workpiece 22 is pivoted clockwise for T₁ (three seconds), it is stopped for T₂ (0.5 second) and may be repeated for T₃ (11 seconds). With this arrangement, a smooth semiconductor wafer can be processed in this embodiment.

Moreover, when the curve displacement of the blade 12 is over the predetermined value, the rotating speed of the blade 12 may be changed, so that the displacement can be returned within the predetermined value.

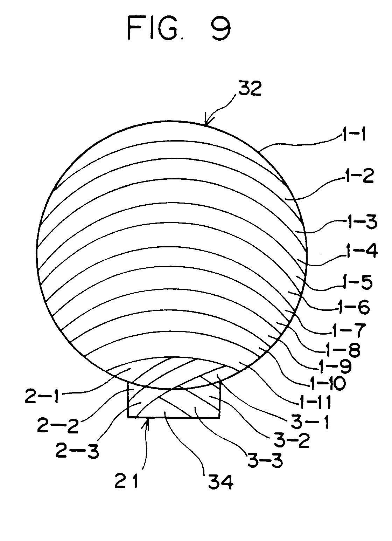

In Fig. 9, cut loci from 1-1 to 1-11 are put on by moving the moving trestle 16, shown in Fig. 1, in the direction of the arrow B and a semiconductor wafer is cut by this operation. And, cut loci from 2-1, 2-2 and 2-3 to 3-1, 3-2 and 3-3 are put on by pivoting the workpiece 22 counterclockwise and clockwise and a semiconductor wafer is cut by this operation. Therefore, the effective blade length of the blade 12 can be reduced more than the diameter of workpiece 22 by the portion of the pivoting cut of a slice base 21. Moreover, the cut remainder part is not left at the center of the cut semiconductor wafer 32.

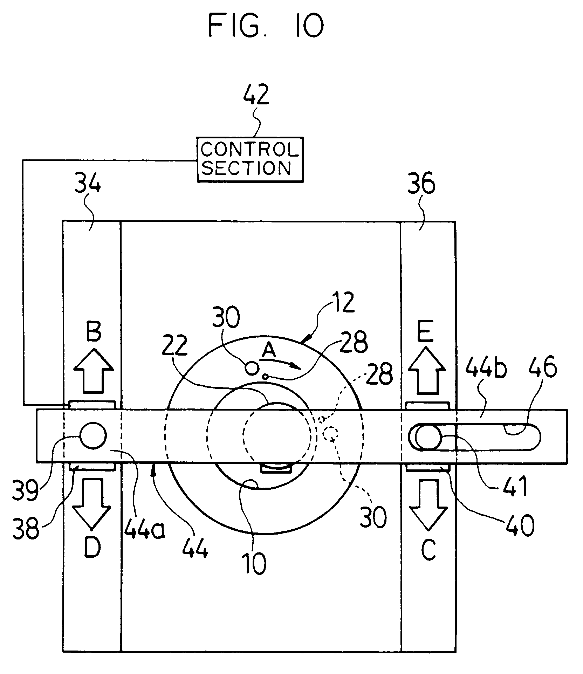

Fig. 10 is the second embodiment of the apparatus for slicing semiconductor wafers according to this invention. The same members as the first embodiment shown in Fig. 1 are given the same numerals and the explanation thereof are omitted.

The inner peripheral cutting edge 10 is rotatable in the direction of the arrow A by the turning effort from the spindle and rails 34 and 36 are located in parallel along both sides of this inner peripheral cutting edge 10.

Sliders 38 and 40 are arranged on the rails 34 and 36, respectively, so that they can travel. The sliders 38 and 40 are driven by instruction signals from a control section 42.

An arm 44 is spanned between the sliders 38 and 40 and a left end portion 44a thereof is supported rotatably by a pin 39 arranged in the slider 38. A rectangular hole 46 is formed in a right end portion 44b of the arm 44 along the direction of the longitudinal side of the arm 44. And, a pin 41 arranged in the slider 40 is fitted slidably in the rectangular hole 46. With this arrangement, the sliders 38 and 40 are moved properly such that the arm 44 can pivot on the plane of the inner peripheral cutting edge 10.

Moreover, the workpiece 22 is fixed about at the center of the arm and suspended through the inner peripheral portion of the inner peripheral cutting edge 10.

According to the apparatus for slicing semiconductor wafers constructed in the above mentioned manner, first, the inner peripheral cutting edge 10 is rotated to the direction of the arrow A, thereafter, the workpiece 22 is moved obliquely to be cut by predetermined value in a state that the slider 38 is moved to the direction of the arrow B by the control section 42 such that the arm 44 is pivoted clockwise and the workpiece 22 is pressed against the grindstone 14 of the inner peripheral cutting edge 10. Next, the remainder part is cut in a state that the slider 40 is moved in the direction of the arrow C by the control section 42 such that the arm 44 is pivoted clockwise and the workpiece 22 is pivoted about the axis thereof by a predetermined value.

Therefore, the effective blade length of the blade 12 can be reduced more than the diameter of the workpiece 22. Moreover, the cut remainder part is not left at the center of the cut semiconductor wafer.

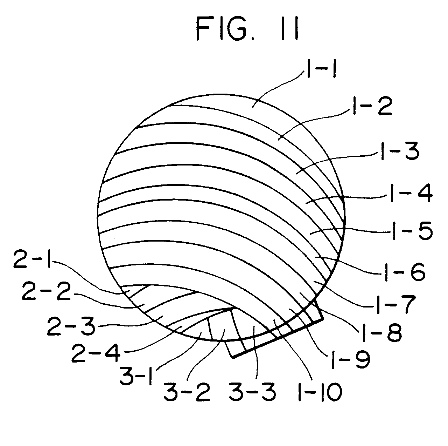

Fig. 11 is an embodiment showing the cut loci on the surface of the semiconductor wafer 32 cut with said apparatus for slicing semiconductor wafers.

In Fig. 11, cut loci from 1-1 to 1-10 are put on by moving the slider 38, shown in Fig. 10, in the direction of the arrow B. And, cut loci from 2-1 to 2-4 are put on by moving the slider 40 in the direction of the arrow C for moving the slider 38 in the direction of the arrow B. Then, cut loci from 3-1 to 3-3 are put on by moving the slider 40 in the direction of the arrow E for moving the slider 38 in the direction of the arrow D. Thus, the cut remainder part is not left at the center of the semiconductor wafer 32.

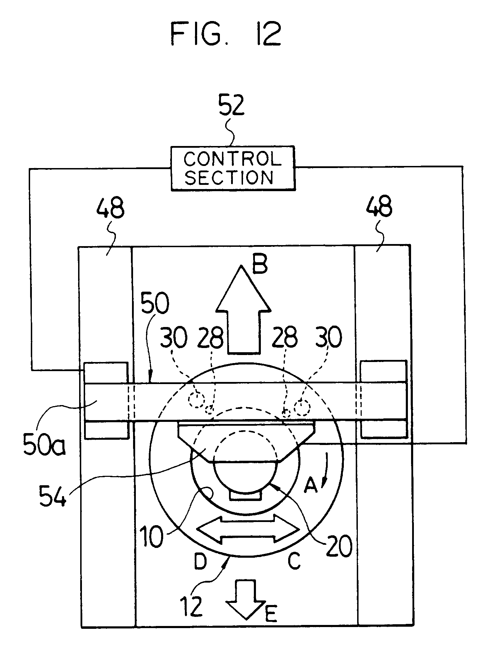

Fig. 12 is the third embodiment of the apparatus for slicing semiconductor wafers according to this invention. The same members as the first embodiment shown in Fig. 1 are given the same numerals and the explanation thereof are omitted.

The inner peripheral cutting edge 10 is rotatable to the direction of the arrow A according by the turning effort from the spindle and rails 48 and 48 are located in parallel along both sides of the inner peripheral cutting edge 10.

A arm 50 is spanned between the rails 48 and 48. A left end portion 50a and right end portion 50b of the arm 50 are arranged slidably at the rail 48 and 48. Further, the arm 50 is movable in the directions of the arrows B and E on the plane of the inner peripheral cutting edge 10 by instruction signals from control section 52.

Moreover, a slide board 54 is attached slidably to the arm 50 along the direction of the longitudinal side of the arm 50. The workpiece 22 is fixed to this slide board 54 and suspended in the inner peripheral portion of the inner peripheral cutting edge 10. The slide board 54 is movable in the directions of the arrows C and D perpendicularly intersecting the directions of the arrows B and E on the plane of the inner peripheral cutting edge 10 by the instruction signals from the control section 52.

According to the apparatus for slicing semiconductor wafers constructed in the above mentioned manner, first, the inner peripheral cutting edge 10 is rotated in the direction of the arrow A, thereafter, for instance, the workpiece 22 is cut by predetermined value in a state that the arm 50 is moved in the direction of the arrow B by the control section 52, the workpiece 22 is moved obliquely and pressed on the grindstone 14 of the inner peripheral cutting edge 10. Next, the remainder part is cut by moving the workpiece 22 to a direction differing from the above-mentioned direction.

With this arrangement, the effective blade length of the blade 12 can be reduced more than the diameter of the workpiece 22. Moreover the cut remainder part does not left at the center of the cut semiconductor wafer.

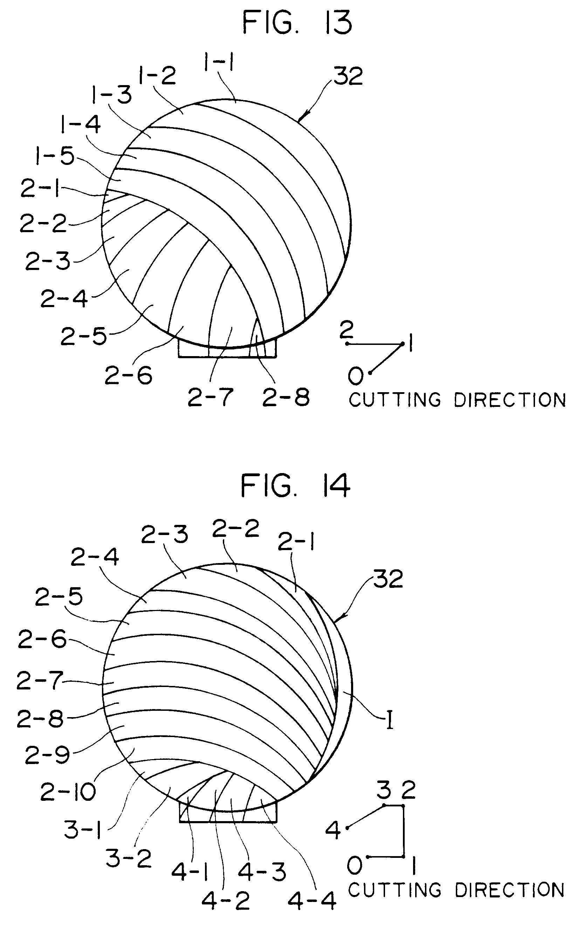

Figs. 13-15 are embodiments showing the cut loci on surfaces of the semiconductor wafer 32 cut with said apparatus for slicing a semiconductor wafer.

In Fig. 13, cut loci from 1-1 to 1-5 are put on by moving the slide board 54 in the direction of the arrow C for moving the arm 50, shown in Fig. 12, in the direction of the arrow B. And, cut loci from 2-1 to 2-3 are put on by moving the slide board 54 in the direction of the arrow C. Thus, the cut remainder part is not left at the center of the semiconductor wafer 32.

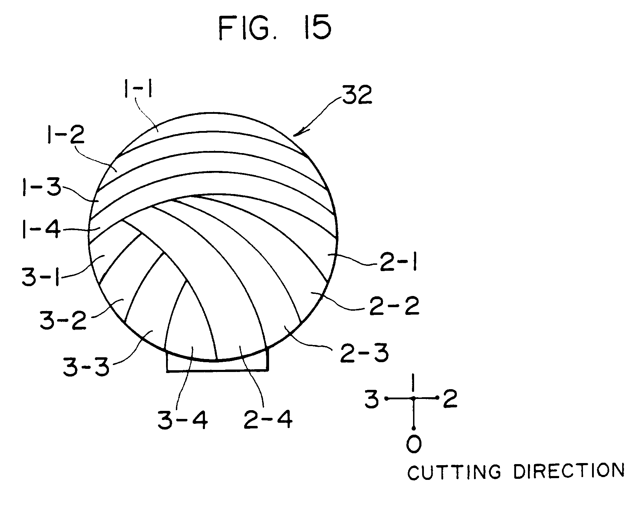

In Fig. 14, a cut locus 1 is put on by moving the slide board 54 in the direction of the arrow C, cut loci from 2-1 to 2-10 are put on by moving the arm 50 in the direction of the arrow B and cut loci 3-1 and 3-2 are put on by moving the slide board 54 in the direction of the arrow C. Further, cut loci from 4-1 to 4-4 are put on by moving the slide board 54 in the direction of the arrow D for moving the arm 50 in the direction of the arrow E. In this case, the cut remainder part is not left at the center of the semiconductor wafer 32.

In Fig. 15, cut loci from 1-1 to 1-4 are put on by moving the arm 50 in the direction of the arrow B and cut loci from 2-1 to 2-4 are put on by moving the slide board 54 in the direction of the arrow C. Further, cut loci from 3-1 to 3-4 are put on by moving the slide board 54 in the direction of the arrow D. In this case, the cut remainder part is not left at the center of the semiconductor wafer 32.

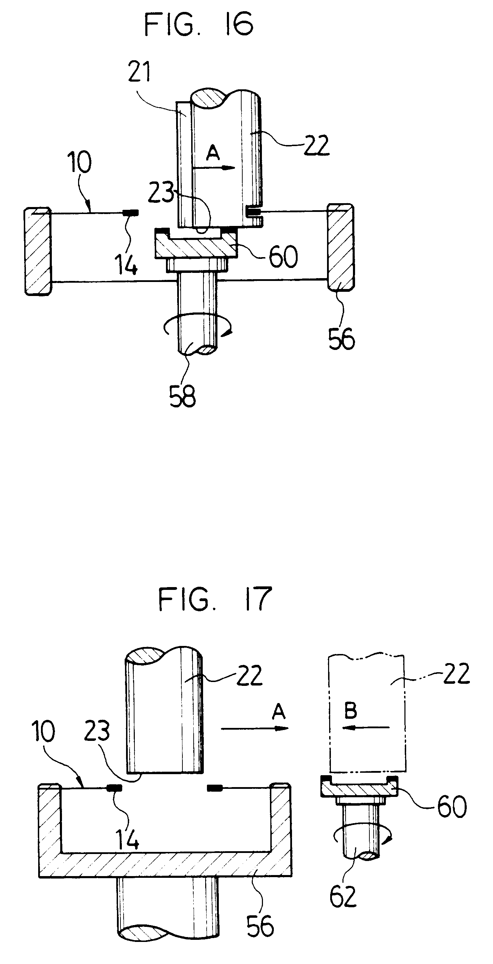

Fig. 16 is the first embodiment showing the the state that a mechanism which surface-grinds the end surface of the workpiece 22 is arranged in the apparatus for slicing a semiconductor wafer shown in Fig. 1, 10 or 12. The surface-grinding mechanism surface-grinds differences formed on the surface of the semiconductor wafer manufactured by the apparatus for slicing semiconductor wafers.

In fig. 16, a grindstone axis 58 is arranged in a hollow spindle 56 in which the inner peripheral cutting edge 10 is arranged and is rotated and movable with the spindle 56. A grindstone 60 for surface-grinding is arranged at the point of the grindstone axis 58. That is, when the semiconductor wafer of work 22 is being cut, the rotating grindstone 60 is applied to a end face 23 of the workpiece 22 and the workpiece 22 or the inner peripheral cutting edge 10 is moved in a relatively approaching direction (the direction of the arrow A), so that, first, the end face 23 can be ground with the grindstone 60, next, the workpiece 22 can be cut into to be a semiconductor wafer with the inner peripheral cutting edge. With this arrangement, the semiconductor wafer is cut from the workpiece 22 and the end face 23 thereof is ground, synchronously.

Moreover, since the end face of a slice base 21 need not be ground when the slice base 21 is cut, the surface-grinding operation may be stopped.

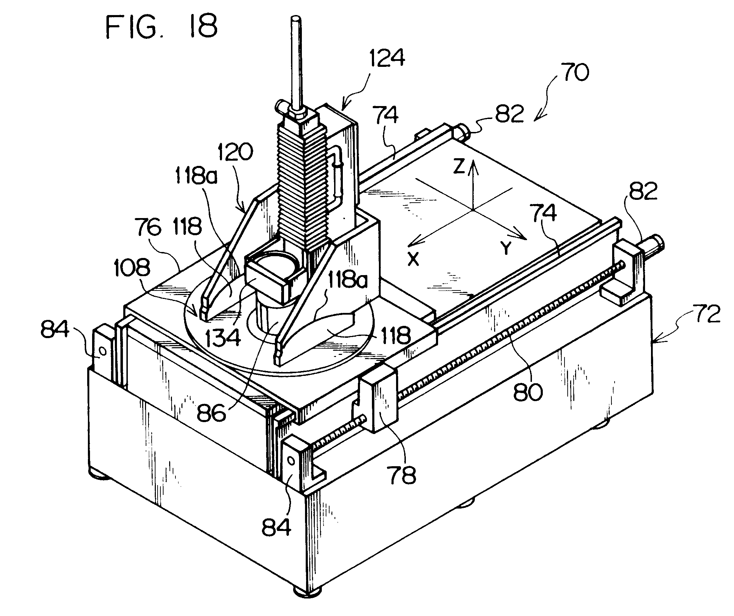

Fig. 17 is the second embodiment showing the the state that a mechanism which surface-grinds is arranged in the apparatus for slicing a semiconductor wafer.

In Fig. 17, a grindstone 62 is arranged at the side of the spindle. The workpiece 22 cut with the inner peripheral cutting edge 10 is moved in the direction of the grindstone axis 62 (the direction of the arrow A) and moved in the direction of the arrow B for touching the grindstone 60, so that the end face 23 of the workpiece 22 can be surface-ground.

In this way, the surface-grinding mechanism shown in Fig. 16 or 17 is arranged in the apparatus for slicing semiconductor wafers according to this invention. Accordingly, the slicing and the surface-grinding processes of the semiconductor wafer can be smoothly performed.

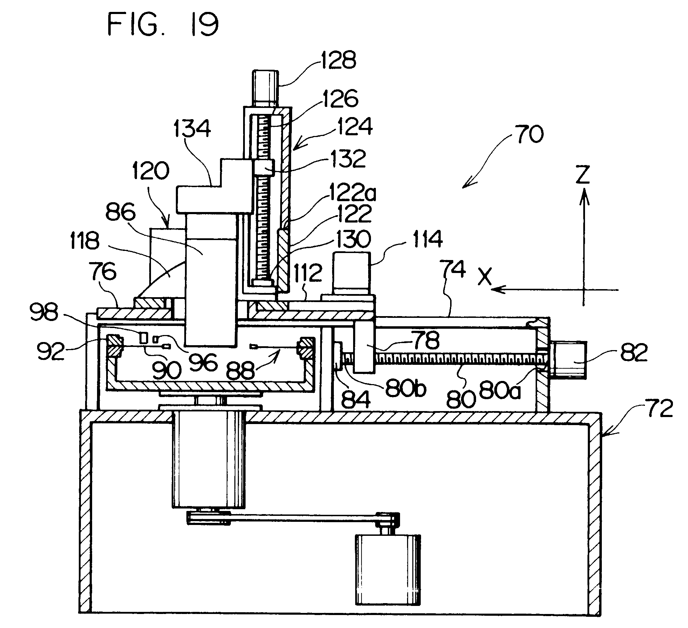

Fig. 18 is a perspective view showing the fourth embodiment of the apparatus 70 for slicing semiconductor wafers according to this invention and Fig. 19 is a section view thereof.

In the apparatus 70 for slicing, guide rails 74 and 74 are located in both sides of a trestle 72 along the direction of X in Fig. 18 and a rectangular X-table 76 is mounted movably thereon. A nut 78 for moving is fastened at the side end portion of the X-table 76 and a screw 80 for moving is arranged in parallel with the guide rail 74 and coupled spirally at the nut 78 for moving. The root end portion 80a of the screw 80 for moving is connected with a driving motor 82 and the point end portion 80b is supported with a bearing 84 fastened to a trestle 72.

With this arrangement, the X-table 76 is moved along the guide rails 74 and 74 by normal rotating the driving motor 82 to be moved in the cutting direction of a workpiece 86 described later.

A inner peripheral cutting edge 88, with which a workpiece 86 is cut to be a wafer, is located under the X-table 76. The inner peripheral cutting edge 88 is made of the doughnut-shaped blade 90 whose inner peripheral edge is electro deposited with the diamond grains. Further, the inner peripheral cutting edge 88 is stretched out at the outer peripheral edge of the blade 90 thereof by a chuck body 92 and rotated at high speed by turning effort from a cup-shaped spindle.

A pair of non-contact type blade sensors 96 and 96 and air pads 98 and 98 are arranged on the blade 90. The blade sensors 96 and 96 are connected with a controller, not shown. The controller controls a air pressure control device, not shown, based on the displacement value of the blade 90 detected by the blade sensors 96 and 96 to operate the air pads 98 and 98. Accordingly, the displacement (warp) of the blade 90 can be corrected.

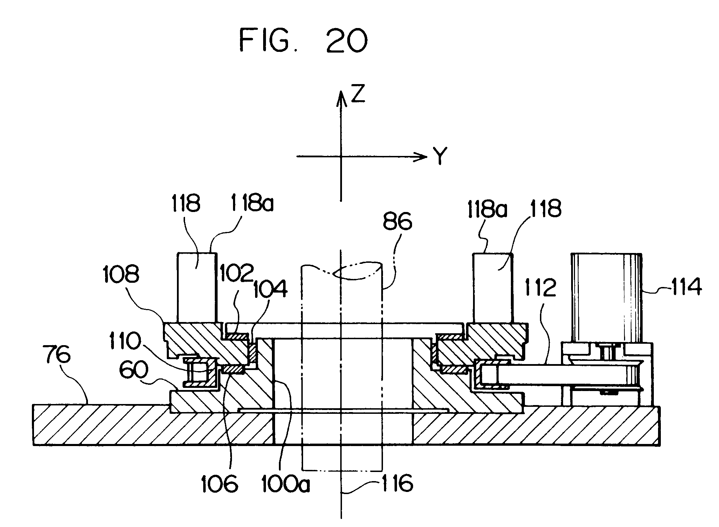

On the other hand, a hollow pedestal 100 is fixed to the X-table 76, as shown in Fig. 20. A disc pivoting table 108 is arranged on the pedestal 100 through three sliding rings 102, 104 and 106. The workpiece 86 (shown by the two-dot chain lines in Fig. 20) is arranged through the table 108 and a hollow part 100a of the pedestal 100. More, a pulley 110 is fastened under the pivoting table 108. The pulley 110 is connected with a pivoting motor 114 through a belt 112 to be capable of transmitting driving force. Therefore, the pivoting motor 114 alternately repeats the counterclockwise and clockwise pivoting the pivoting table 108 can pivot about a center axis 116 of the pivoting table 108.

A pair of tilting bases 118 and 118 shaped as semicircle boards are installed on the pivoting table 108 as shown in Fig. 18. The tilting base 118 is slidable in the X-direction and positioned at the predetermined position on the surface of the pivoting table 108.

A tilting column 120 is mounted slidably on the bow-shaped slide surfaces 118a and 118a of the tilting bases 118 and 118 shown in Fig. 18. A tilting base 122 shown in Fig. 19 is fixed on the tilting column 120. The tilting base 122 is arranged in the perpendicular direction of the tilting base 118, that is, in the Y-direction and a indexing part 124 of the workpiece 86 is put slidably on the bow-shaped slide surface 122a of the tilting base 122. With this arrangement, the indexing part 124 is tilted by the tilting bases 118 and 118 in the X-direction and by the tilting base 122 in the Y-direction.

The indexing part 124 has a indexing screw 126 arranged in the indexing direction of the workpiece 86, that is, the Z-direction. A upper end portion of the indexing screw 126 is connected with a driving motor 128 and a lower end portion is supported with a bearing 130 of the indexing part 124. More, a indexing nut 132 is fixed spirally on the indexing screw 126 and an index head 134 to which the upper end portion of the workpiece 86 is adhered is fastened to the indexing nut 132. Therefore, the driving motor 128 is driven for the predetermined time, so that the workpiece 86 can be indexed by the thickness for one piece wafer in the Z-direction.

Next, a description will be given of a method of cutting the wafer with the apparatus 70 for slicing semiconductor wafers constructed in the above mentioned manner.

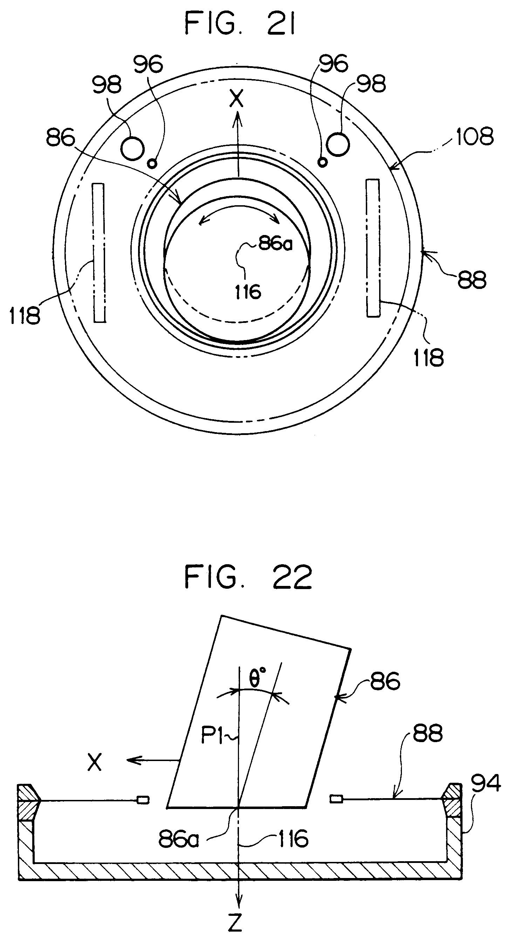

In the first cutting method, first, the workpiece 86 is tilted along the tilting bases 118 and 120 through an angle of θ° in Figs. 21 and 22, whereby the wafer is set to be cut along the crystal face of the workpiece 86.

Next, the tilting bases 118 and 118 is positioned on the pivoting table 108 such that the center 86a in the cutting surface of the workpiece 86 is corresponding to the center axis 116 of the pivoting table 108.

Thereafter, the driving motor 128 in the indexing part 124, shown in Fig. 19, is driven, whereby the workpiece 86 are moved by the thickness for the one piece wafer in the Z-direction.

Then, the inner peripheral cutting edge 88 is rotated and the X-table 76 is moved in the X-direction such that the workpiece 86 is pressed against the inner peripheral cutting edge 88.

Further, the pivoting motor 114 shown in Fig. 20 is driven to pivot the pivoting table 108 by the predetermined value in both directions while the workpiece 86 is moved to approach the inner peripheral cutting edge 88.

Therefore, according to the first cutting method, the workpiece 86 is cut for being pivoted about the axis P1 which passes the center 86a in the cutting surface and perpendicularly intersects the surface of the blade 90, so that the effective blade length of the blade 90 can be reduced more than the diameter of the workpiece 86. Moreover, the cut remainder part is not left at the center of the cut semiconductor wafer.

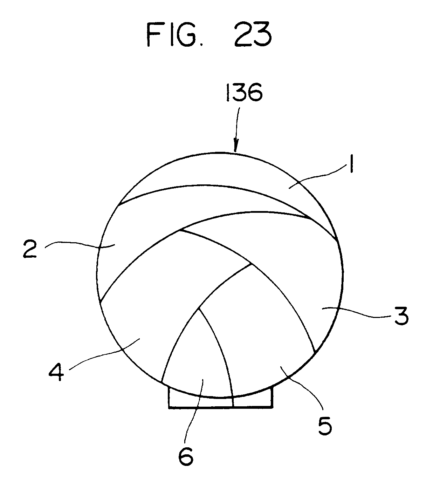

Fig. 23 is an embodiment showing cut loci on the surface of the semiconductor wafer 136 cut according to the first cutting method.

In Fig. 23, the cut loci of 1-6 are put on by pivoting the workpiece 86, shown in Fig. 22, about the center 86a in the cutting surface thereof for moving the workpiece 86 in the X-direction. Therefore, the cut remainder part as shown in Fig. 23 is not left at the center of the semiconductor wafer 136.

Moreover, when the intermittently cutting is performed in the first cutting method, the semiconductor wafer 136 having the cut loci shown in Fig. 5 can be manufactured.

In this case, alternately, the moving and stopping operations may be controlled according to the displacement of the blade 90, or a moving time T₁, a stopping time T₂ and an intermittently pivoting time T₃ are predetermined, whereby an intermittently cutting shown in Fig. 8 may be performed. Thus, the smooth semiconductor wafer 136 can be manufactured in this embodiment.

Further, when the return displacement of the blade 90 exceeds the predetermined value, the rotating speed thereof may be changed such that the displacement can be returned within the predetermined value.

Hereafter, the second cutting method will be explained.

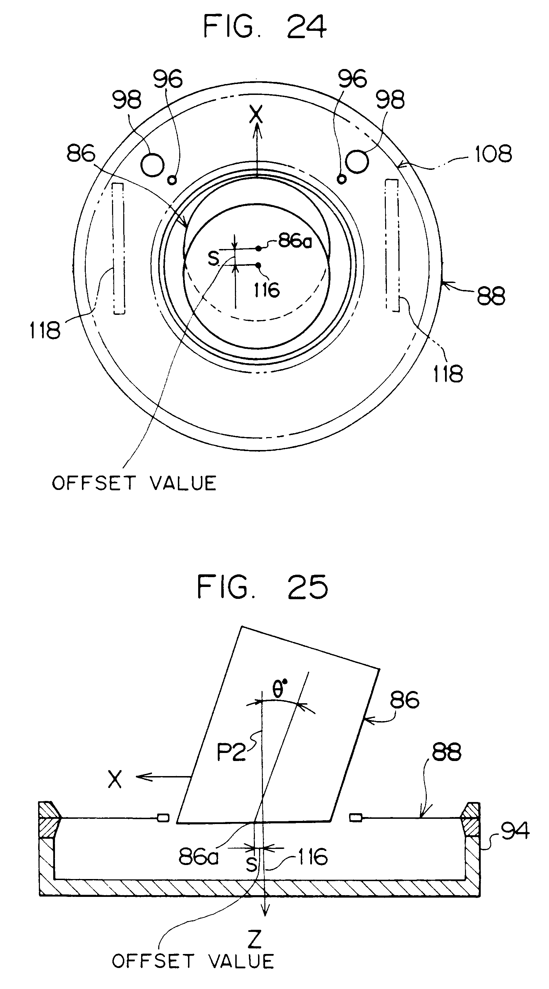

First , the workpiece 86 is tilted along the tilting bases 118 and 120 through an angle of θ° shown in Figs. 24 and 25, whereby the wafer is set to be cut along the crystal face of the workpiece 86.

Next, the tilting bases 118 and 118 are moved by the predetermined value from the position of Fig. 21 in the X-direction, so that the center 86a of the workpiece 86 can be positioned to shift by a size S from the center axis 116 of the pivoting table 108 in the X-direction.

Thereafter, the driving motor 128 on the indexing part 124 shown in Fig. 19 is driven, whereby the workpiece 86 is moved by the thickness for one piece wafer in the Z-direction.

Then, the inner peripheral cutting edge 88 is rotated and the-X table 76 is moved in the X-direction such that the workpiece 86 is pressed against the inner peripheral cutting edge 88.

The pivoting motor 114, shown in Fig. 20, is driven to pivot the pivoting table 108 by the predetermined value in both directions while the workpiece 86 is approached to the inner peripheral cutting edge 88.

With this arrangement, according to second cutting method, the workpiece 86 is cut for being pivoted about the axis P2 passing through a position shifted from the center 86a in the cutting surface thereof and perpendicularly intersecting the surface of the blade 90, so that the effective blade length of the blade 90 can be reduced more than the diameter of the workpiece 86 as in the case of the first cutting method. Moreover, the cut remainder part is not left at the center of the cut semiconductor wafer.

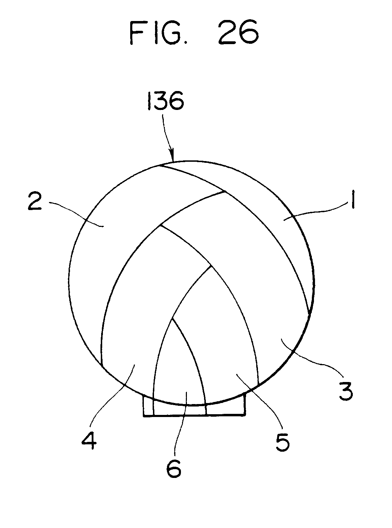

Fig. 26 is an embodiment showing the cut loci on surface 136 of the semiconductor wafer cut according to the second cutting method.

In Fig. 26, the cut loci of 1-6 are put on by pivoting the workpiece 86, shown in Fig. 25, about the position shifted from the center 86a in the cutting surface thereof by the size S for moving the workpiece 86 in the X-direction. Therefore, the cut remainder part as shown in Fig. 26 is not left at the center of the semiconductor wafer 136.

Moreover, when the intermittently cutting is performed in the second cutting method, the semiconductor wafer 136 having the cut loci shown in Fig. 5 can be manufactured.

In this case, alternately, the moving and stopping operations may be controlled according to the displacement of the blade 90, or a moving time T₁, a stopping time T₂ and an intermittently pivoting time T₃ are predetermined, whereby an intermittently cutting shown in Fig. 8 may be performed. Thus, the smooth semiconductor wafer 136 can be manufactured in this embodiment.

Further, when the return displacement of the blade 90 exceeds the predetermined value, the rotating speed thereof may be changed such that the displacement can be returned within the predetermined value.

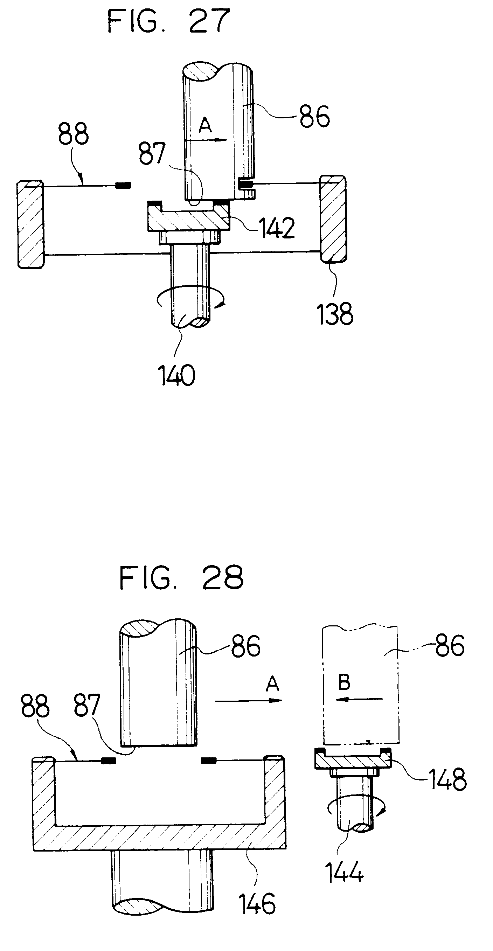

Fig. 27 is the first embodiment showing the the state that a mechanism which surface-grinds the end surface of the workpiece 86 is arranged in the apparatus 70 for slicing semiconductor wafers shown in Fig. 18. The surface-grinding mechanism surface-grinds differences formed on the surface of the semiconductor wafer manufactured by the apparatus 70 for slicing a semiconductor wafer.

In fig. 27, the inner peripheral cutting edge 88 is fitted to a hollow spindle 138 and a grindstone axis 140 is located in spindle 138. The grindstone axis 140 is rotatable and movable with spindle 138. rotated and movable with the spindle 56. A grindstone 142 for surface-grinding is arranged at the point of grindstone axis 140. That is, when the wafer of workpiece 86 is being cut, the rotating grindstone 142 is applied to a end face 87 of the workpiece 86 and the workpiece 86 or the inner peripheral cutting edge 88 is moved in a relatively approaching direction (the direction of the arrow A), so that, first, the end face 87 is ground with the grindstone 142, next, the workpiece 86 is cut into to be a semiconductor wafer with the inner peripheral cutting edge. With this arrangement, the semiconductor wafer is cut from the workpiece 86 and the end face 87 thereof can be ground.

Fig. 28 is the second embodiment showing the the state that a surface-grinding mechanism is arranged in the apparatus for slicing a semiconductor wafer.

The workpiece 86 cut with the inner peripheral cutting edge 88 is moved in the direction of the grindstone axis 144 (the direction of the arrow A) and then moved in the direction of the arrow B for touching the grindstone 148, so that the end face 87 of the workpiece 86 can be surface-ground.

In this way, the surface-grinding mechanism shown in Fig. 27 or 28 is arranged in the apparatus 70 for slicing a semiconductor wafer according to this invention. Accordingly, the slicing and the surface-grinding processes of the semiconductor wafer can be smoothly performed.

## Claims

1. A method of slicing a semiconductor wafer (32) comprising the steps of:
rotating an inner peripheral cutting edge (10) formed on an inner peripheral edge of a doughnut-shaped blade (12) and
pressing a columnar semiconductor material (22) against the inner peripheral cutting edge (10), while performing a cutting operation,
linearly moving at least one of the inner peripheral cutting edge (10) and the semiconductor material (22) relative to each other by a predetermined value while performing the cutting operation in a cutting plane;
**characterized** by the following steps:
(1) pivoting said semicoductor material (22) in said cutting plane in a counter clockwise direction to a first predetermined angle, (a) nearly moving at least one of the inner peripheral cutting edge (10) and the semiconductor material (22) relatively closer to each other to perform a first cutting operation for a predetermined time T₁, thereafter, (b) stopping the first cutting operation for a predetermined time T₂ by stopping said linear movement and repeating said steps (a) and (b) for a predetermined time T₃;
(2) pivoting said semiconductor material (22) in the clockwise direction to a second predetermined angle, (a) nearly moving at least one of the inner peripheral cutting edge (10) and the semiconductor material (22) relatively closer to each other to perform a second cutting operation for a predetermined time T₁, thereafter, (b) stopping the second cutting operation for a predetermined time T₂, by stopping said linear movement and repeating said steps (a) and (b) for a predetermined time T₃; and
repeating steps (1) and (2) to manufacture said semiconductor wafer (32).

2. The method as set forth in claim 1, wherein said pivoting of said semiconductor material (22) takes place about an axis of said semiconductor material (22).

3. The method as set forth in claim 1, wherein said semiconductor material (86) is inclined to a surface of the blade (90) by a predetermined angle and pivoted about an axis passing through a center of a cut surface of said semiconductor material (86) and perpendicularly intersecting the surface of the blade (90).

4. The method as set forth in claim 1, wherein said semiconductor material (86) is inclined to a surface of the blade (90) by a predetermined angle and pivoted about an axis passing through a position shifted from a center of a cut surface of said semiconductor material (86) by a predetermined value and perpendicularly intersecting the surface of the blade (90).

5. An apparatus for slicing a semiconductor wafer (32) comprising a doughnut-shaped blade (12) having on an inner peripheral edge thereof an inner peripheral cutting edge (10), rotating means for rotating said inner peripheral cutting edge (10) of said doughnut-shaped blade (12) and moving means for nearly moving at least one of said inner peripheral cutting edge (10) and a columnar semiconductor material (22) relative to each other while performing a cutting operation by pressing said semiconductor material (22) against said peripheral cutting edge (10);
said linearly moving means (78, 80, 82) are arranged for intermittently moving at least one of the inner peripheral cutting edge (88) and the semiconductor material (86) relatively closer to each other;
**characterized by**:
pivoting means for pivoting the semiconductor material (86) in a counterclockwise direction by a predetermined angle and in a clockwise direction by a predetermined angle, alternately; and
control means for driving said linearly moving means (78, 80, 82) and said pivoting means according to the method as claimed in any of preceding claims.

6. The apparatus as set forth in claim 5, wherein said pivoting means pivotes said semiconductor material (22) about an axis of said semiconductor material (22).

7. The apparatus as set forth in claim 5 or 6, further comprising tilting means (118, 120) for inclining said semiconductor material (86) to a surface of the blade (90) by a predetermined angle and said pivoting means pivotes about an axis passing through a center of a cut surface of said semiconductor material (86) and perpendicularly intersects the surface of the blade (90).

8. The apparatus as set forth in claim 5 or 6, wherein said pivoting ans pivotes said semiconductor material (86) about an axis passing through a position shifted from the cut surface of said semiconductor material (86) by a predetermined value (s) and perpendicularly intersecting the surface of the blade (90).

9. The apparatus as set forth in any of claims 5 to 8, further comprising grinding means (60; 142; 148) for grinding at least one of the semiconductor wafer (32) while being cut and a planar surface of the semiconductor wafer (32) after being cut.

## Patentansprüche

1. Verfahren zum Abschneiden einer Halbleiterscheibe (32), welches die folgenden Schritte aufweist:
Drehbewegen einer Innenumfangsschneidkante (10), welche an einem Innenumfangsrand einer ringförmigen Schneideinrichtung (12) ausgebildet ist,
Andrücken eines säulenförmigen Halbleitermaterials (22) gegen die Innenumfangsschneidkante (10) zur Ausführung eines Schneidvorgangs, und
lineares Bewegen wenigstens der Innenumfangsschneidkante (10) oder des Halbleitermaterials (22) relativ zueinander um einen vorbestimmten Wert unter Ausführung des Schneidvorgangs in einer Schneidebene;
**gekennzeichnet durch** die folgenden Schritte:
(1) Verdrehen des Halbleitermaterials (22) in der Schneidebene in Gegenuhrzeigerrichtung um einen vorbestimmten Winkel, (a) lineares Bewegen wenigstens der Innenumfangsschneidkante (10) oder des Halbleitermaterials (22) näher aufeinander zu, um einen ersten Schneidvorgang für eine vorbestimmte Zeit T₁ auszuführen, anschließend (b) Anhalten des ersten Schneidvorganges für eine vorbestimmte Zeit T₂ durch Anhalten der linearen Bewegung, und Wiederholen der Schritte (a) und (b) für eine vorbestimmte Zeit T₃;
(2) Verdrehen des Halbleitermaterials (22) in Uhrzeigerrichtung um einen vorbestimmten Winkel, (a) lineares Bewegen wenigstens der Innenumfangsschneidkante (10) oder des Halbleitermaterials (22) relativ näher aufeinander zu, um einen zweiten Schneidvorgang für eine vorbestimmte Zeit T₁ auszuführen, anschließend (b) Anhalten des zweiten Schneidvorgangs für eine vorbestimmte Zeit T₂ durch Anhalten der linearen Bewegung und Wiederholen der Schritte (a) und (b) für eine vorbestimmte Zeit T₃; und
Wiederholen der Schritte (1) und (2) zur Herstellung der Halbleiterscheibe (32).

2. Verfahren nach Anspruch 1, bei dem das Verdrehen des Halbleitermaterials (22) um eine Achse des Halbleitermaterials (22) erfolgt.

3. Verfahren nach Anspruch 1, bei dem das Halbleitermaterial (86) zu einer Oberfläche der Schneideinrichtung (90) um einen vorbestimmten Winkel geneigt ist und um eine Achse verdreht ist, welche durch einen Mittelpunkt einer Schneidfläche des Halbleitermaterials (86) geht und senkrecht die Fläche der Schneideinrichtung (90) schneidet.

4. Verfahren nach Anspruch 1, bei dem das Halbleitermaterial (86) zu einer Oberfläche der Schneideinrichtung (90) um einen vorbestimmten Winkel geneigt und um eine Achse verdreht ist, welche durch eine Position geht, die von einem Mittelpunkt einer Schneidfläche des Halbleitermaterials (86) um einen vorbestimmten Wert verschoben ist und die Oberfläche der Schneideinrichtung (90) senkrecht schneidet.

5. Vorrichtung zum Abschneiden einer Halbleiterscheibe (32), welche eine ringförmige Schneideinrichtung (12) aufweist, welche an einem inneren Umfangsrand eine Innenumfangsschneidkante (10) hat, mit einer Dreheinrichtung, welche die Innenumfangsschneidkante (10) der ringförmigen Schneideinrichtung (12) in Drehung versetzt, und eine Bewegungseinrichtung, welche wenigstens die Innenumfangsschneidkante (10) oder ein säulenförmiges Halbleitermaterial (22) relativ zueinander unter Ausführung eines Schneidvorganges linear bewegt und das Halbleitermaterial (22) gegen die Umfangsschneidkante (10) angedrückt wird; und
die linearen Bewegungseinrichtungen (78, 80, 82) derart ausgelegt sind, daß wenigstens die Innenumfangsschneidkante (88) oder das Halbleitermaterial (86) intermittierend näher aufeinander zu bewegt werden;
**gekennzeichnet durch**:
eine Verdreheinrichtung zum wechselweisen Verdrehen des Halbleitermaterials (86) in eine Gegenuhrzeigerrichtung um einen vorbestimmten Winkel und in eine Uhrzeigerrichtung um einen vorbestimmten Winkel; und
eine Steuereinrichtung zum Antreiben der linearen Bewegungseinrichtung (78, 80, 82) und der Verdreheinrichtung nach Maßgabe des Verfahrens nach einem der vorangehenden Ansprüche.

6. Vorrichtung nach Anspruch 5, bei der die Verdreheinrichtung das Halbleitermaterial (22) um eine Achse des Halbleitermaterials (22) verdreht.

7. Vorrichtung nach Anspruch 5 oder 6, welche ferner eine Kippeinrichtung (118, 120) aufweist, welche das Halbleitermaterial (86) zu einer Oberfläche der Schneideinrichtung (90) um einen vorbestimmten Winkel neigt und die Verdreheinrichtung das Halbleitermaterial um eine Achse verdreht, die durch einen Mittelpunkt einer Schneidfläche des Halbleitermaterials (86) geht und die Oberfläche der Schneideinrichtung (90) senkrecht schneidet.

8. Vorrichtung nach Anspruch 5 oder 6, bei der die Verdreheinrichtung das Halbleitermaterial (86) um eine Achse verdreht, die durch eine Position geht, welche von einem Mittelpunkt einer Schneidfläche des Halbleitermaterials (86) um einen vorbestimmten Wert (s) verschoben ist und die Oberfläche der Schneideinrichtung (90) senkrecht schneidet.

9. Vorrichtung nach einem der Ansprüche 5 bis 8, welche ferner eine Schleifeinrichtung (60; 142; 148) aufweist, welche wenigstens eine der Halbleiterscheiben (32) schleift während diese abgeschnitten wird, und eine planare Oberfläche der Halbleiterscheibe (32) nach dem Abschneiden schleift.

## Revendications

1. Procédé de découpage d'une plaquette semi-conductrice (32) comprenant les phases suivantes :
on fait tourner un bord coupant périphérique interne (10) qui est prévu sur le bord périphérique interne d'une lame torique (12),
on presse une matière semi-conductrice en colonnette (22) contre le bord coupant périphérique interne (10), tout en accomplissant une opération de coupe,
on déplace linéairement au moins soit le bord coupant périphérique interne (10), soit la matière semi-conductrice (22), l'un par rapport à l'autre, d'une valeur prédéterminée, tout en accomplissant l'opération de coupe dans un plan de coupe,
**caractérisé** par les phases suivantes :
on fait pivoter ledit matériau semi-conducteur (22) dans ledit plan de coupe, dans le sens contraire des aiguilles d'une montre, d'un angle prédéterminé, (a) on déplace linéairement au moins soit le bord coupant périphérique interne (10), soit le matériau semi-conducteur (22), relativement près l'un de l'autre pour faire une première opération de coupe pendant un temps prédéterminé T₁, ensuite (b) on arrête la première opération de coupe pendant un temps prédéterminé T₂ en artêtant ledit déplacement linéaire, et on répète lesdites phases (a) et (b) pendant un temps prédéterminé T₃;
on fait pivoter ledit matériau semi-conducteur (22) dans le sens des aiguilles d'une montre, d'un second angle prédéterminé, (a) on déplace linéairement au moins soit le bord coupant périphérique interne (10), soit le matériau semi-conducteur (22), relativement près l'un de l'autre pour faire une seconde opération de coupe pendant un temps prédéterminé T₁, ensuite (b) on arrête la seconde opération de coupe pendant un temps prédéterminé T₂ en arrêtant ledit déplacement linéaire, et on répète lesdites phases (a) et (b) pendant un temps prédéterminé T₃; et
on répète les phases (1) et (2) pour fabriquer ladite plaquette semi-conductrice (32).

2. Procédé suivant la revendication 1, dans lequel ledit pivotement dudit matériau semi-conducteur (22) a lieu autour d'un axe dudit matériau semi-conducteur (22).

3. Procédé suivant la revendication 1, dans lequel ledit matériau semi-conducteur (86) est incliné par rapport à la surface de la lame (90), d'un angle prédéterminé et pivote autour d'un axe passant par le centre d'une surface de coupe dudit matériau semi-conducteur (86) et qui coupe perpendiculairement la surface de la lame (90).

4. Procédé suivant la revendication 1, dans lequel ledit matériau semi-conducteur (86) est incliné par rapport à la surface de la lame (90), d'un angle prédéterminé et pivote autour d'un axe passant par une position décalée par rapport au centre d'une surface de coupe dudit matériau semi-conducteur (86), d'une valeur prédéterminée et qui coupe perpendiculairement la surface de la lame (90).

5. Dispositif destiné à découper une plaquette de semi-conducteur (32) comprenant une lame torique (12) ayant, sur son bord périphérique interne, un bord de coupe périphérique interne (10), un moyen de rotation pour faire tourner ledit bord coupant périphérique interne (10) de ladite lame torique (12), et un moyen de déplacement pour faire linéairement se déplacer au moins soit le bord coupant périphérique interne (10), soit le matériau semi-conducteur en colonnette (22) par rapport à l'autre, tout en accomplissant une opération de coupe en pressant ledit matériau semi-conducteur (22) contre ledit bord coupant périphérique interne (10);
ledit moyen de déplacement linéaire (78, 80, 82) étant prévu pour déplacer par intermittence au moins soit le bord coupant périphérique interne (88) et le matériau semi-conducteur (86) par rapport à l'autre ;
**caractérisé par** :
un moyen de pivotement pour faire pivoter le matériau semi-conducteur (86) dans le sens contraire des aiguilles d'une montre, d'un angle prédéterminé, et alternativement dans le sens des aiguilles d'une montre ; et
une moyen de commande pour entraîner ledit moyen de déplacement linéaire (79, 80, 82) et ledit moyen de pivotement suivant une méthode mentionnée dans l'une quelconque des revendications précédentes.

6. Dispositif suivant la revendication 5, dans lequel ledit moyen de pivotement fait tourner ledit matériau semi-conducteur (22) autour d'un axe dudit matériau semi-conducteur (22).

7. Dispositif suivant la revendication 5 ou 6, dans lequel est encore compris un moyen de basculement (118, 120) pour incliner ledit matériau semi-conducteur (86) par rapport à la surface de la lame (90), d'une angle prédéterminé, et ledit moyen de pivotement tourne autour d'un axe passant par le centre d'une surface de coupe dudit matériau semi-conducteur (86) et qui coupe perpendiculairement la surface de la lame (90).

8. Dispositif suivant la revendication 5 ou 6, dans lequel ledit moyen de pivotement fait tourner ledit matériau semi-conducteur (86) autour d'un axe passant par une position décalée par rapport à la surface de coupe dudit matériau semi-conducteur (86) d'une valeur prédéterminée (s) et qui coupe perpendiculairement la surface de la lame (90).

9. Dispositif suivant la revendication 5 ou 6, dans lequel est encore compris un moyen de meulage (60; 142; 148) pour meuler au moins soit la plaquette semi-conductrice (32), tout en la coupant, soit une surface planaire de la plaquette semi-conductrice (32), après l'avoir coupée.
